# DEMANDE DE BREVET EUROPEEN

(11) **EP 4 823 260 A1**
(43) Date de publication de la demande: **14.10.2026**
(21) Numéro de dépôt: 26164816.6
(22) Date de dépôt: 13.03.2026
(51) Int. Cl.: H05K 7/20, F17C 13/00, F25B 9/10, F25D 19/00, G06N 10/40, H10W 40/30

(54) **SYSTEME D'INTERPOSEUR THERMIQUE**

(30) Priorité: 07.04.2025 FR 2503630
(71) Demandeur: Commissariat à l'Energie Atomique et aux Energies Alternatives, 75015 Paris (FR)
(72) Inventeur: DE LA BROISE, Xavier, 38054 Grenoble Cedex 09 (FR); CHARBONNIER, Jean, 38054 Grenoble Cedex 09 (FR); SAUVAGEOT, Jean-Luc, 38054 Grenoble Cedex 09 (FR)
(74) Mandataire: Atout PI Laplace

(57) **Abrégé**

L'invention se rapporte à un système d'interposeur thermique (5) comprenant un circuit intégré dit inférieur (1) et un circuit intégré dit supérieur (2), le circuit inférieur (1) étant configuré pour être couplé thermiquement à un premier étage thermique d'un cryostat, le circuit supérieur (2) étant configuré pour être couplé thermiquement à un deuxième étage thermique du cryostat, le circuit inférieur (1) étant positionné dans une enceinte (3) comprenant une ouverture (4), l'enceinte (3) étant configurée pour être couplée thermiquement à un troisième étage thermique du cryostat, le système (5) comprenant également un circuit intégré dit médian (6) disposé dans l'enceinte (3), au niveau de ladite ouverture (4) de façon à ce que le circuit médian (6) ferme l'ouverture (4), et dans lequel le circuit inférieur (1), le circuit supérieur (2) et le circuit médian (6) sont empilés selon un axe (7) perpendiculaire au plan de l'ouverture (4).

## Description

### Domaine technique

L'invention se rapporte au domaine des composants électroniques utilisés dans des systèmes cryogéniques, et à la façon de les connecter. En particulier, l'invention se rapporte à un système d'interposeur thermique, ainsi qu'à un procédé de fabrication d'un système d'interposeur thermique.

De plus en plus d'équipements scientifiques ont besoin d'une température de fonctionnement sub-kelvin (bits quantiques, détecteurs spatiaux sub-mm et microcalorimètres à rayons X, etc.). Ces équipements sont confrontés à des défis thermiques et architecturaux dans la gestion de la dissipation de puissance des circuits électroniques embarqués.

En effet, la lecture des détecteurs à basse température utilisés par exemple dans les microcalorimètres à rayons X nécessite la proximité des composants de contrôle des détecteurs (notamment les résistances de polarisation ou de shunt, l'électronique de multiplexage et de préamplification, etc.).

Les raisons de cette proximité sont multiples, toutes visant à améliorer les performances : minimisation des impédances parasites, sensibilité réduite aux bruits électromagnétiques rayonnés et aux vibrations, vitesse d'interaction plus élevée, contraintes d'intégration dues au nombre et à la densité des détecteurs à équiper, etc.

Cette proximité nécessite donc généralement de placer ces composants sur le même étage thermique que les détecteurs, alors que leur fonctionnement ne nécessite pas intrinsèquement des températures aussi basses.

Or, ces composants génèrent de la chaleur et dissipent au final sur l'étage le plus froid bien plus de chaleur que celle strictement induite par les détecteurs eux-mêmes, alors que la puissance de refroidissement des cryogénérateurs est extrêmement limitée, notamment dans les applications spatiales.

Ce problème est aujourd'hui le principal obstacle pratique à l'augmentation du nombre de pixels dans les matrices de détection, alors qu'une telle augmentation serait nécessaire pour améliorer la précision de la mesure.

Le problème est exactement le même dans le domaine de l'électronique quantique et des qubits : l'électronique de contrôle/commande doit être très proche des qubits, mais l'électronique de contrôle/commande est très dissipative et empêche donc la multiplication des qubits qui serait nécessaire pour constituer de véritables processeurs quantiques, répondant aux attentes placées dans cette nouvelle technologie.

La solution a consisté, jusqu'à présent, à déplacer au maximum les composants de contrôle dissipatifs vers des étages thermiques plus élevés, en utilisant des câbles et des nappes ; toutefois, chacune de ces interconnexions génèrent autant de fuites thermiques. Certes, ces fuites peuvent être limitées par l'allongement des interconnexions, mais cela conduit vite à des problèmes insolubles de complexité, de compacité et de performance.

La présente invention vise donc à fournir un système qui permet d'assurer une proximité entre les composants utilisés dans des applications d'informatique quantique et/ou dans des détecteurs fonctionnant à très basse température, tout en limitant les flux de chaleur entre ces composants.

### Résumé de l'invention

Un objet de l'invention est donc un système d'interposeur thermique comprenant un circuit intégré dit inférieur et un circuit intégré dit supérieur, le circuit inférieur étant configuré pour être couplé thermiquement à un premier étage thermique d'un cryostat, le circuit supérieur étant configuré pour être couplé thermiquement à un deuxième étage thermique du cryostat, le circuit inférieur étant positionné dans une enceinte comprenant une ouverture, l'enceinte étant configurée pour être couplée thermiquement à un troisième étage thermique du cryostat, le système comprenant également un circuit intégré dit médian disposé dans l'enceinte, au niveau de ladite ouverture de façon à ce que le circuit médian ferme l'ouverture, et dans lequel le circuit inférieur, le circuit supérieur et le circuit médian sont empilés selon un axe perpendiculaire au plan de l'ouverture.

Avantageusement, l'enceinte comprend une partie basse ayant une base de partie basse et une partie haute ayant une base de partie haute, la partie basse et la partie haute étant adjacentes l'une par rapport à l'autre, le circuit inférieur et le circuit médian étant disposés dans la partie basse, la partie haute ayant une hauteur supérieure à la hauteur de la partie basse, un couvercle refermant les la partie haute et la partie basse, le circuit inférieur étant disposé sur une plaque de support qui s'étend dans la partie haute et dans la partie basse, dans lequel un ensemble d'au moins une colonne s'étend sur la hauteur de la partie haute, entre la plaque de support et la base de la partie haute.

Avantageusement, l'ensemble d'au moins une colonne comprend trois colonnes réparties sensiblement à équidistance l'une de l'autre.

Avantageusement, un tube principal débouche sur le couvercle, le tube principal comprenant en son sein un premier tube interne configuré pour coupler thermiquement le circuit inférieur au premier étage thermique, et un deuxième tube interne configuré pour contenir au moins un conducteur électrique pour l'émission/réception de signaux électriques.

Avantageusement, un piège à rayonnements infra-rouges est aménagé à la jonction entre le couvercle et une façade de la partie haute.

L'invention se rapporte également à un système d'interposeur thermique comprenant un circuit intégré dit inférieur et un circuit intégré dit supérieur, le circuit inférieur étant configuré pour être couplé thermiquement à un premier étage thermique d'un cryostat, le circuit supérieur étant configuré pour être couplé thermiquement à un deuxième étage thermique du cryostat, le circuit supérieur étant positionné dans une enceinte comprenant une ouverture, l'enceinte étant configurée pour être couplée thermiquement à un troisième étage thermique du cryostat, le système comprenant également un circuit intégré dit médian disposé à l'extérieur de l'enceinte, au niveau de ladite ouverture, de façon à ce que le circuit médian ferme l'ouverture, et dans lequel le circuit inférieur, le circuit supérieur et le circuit médian sont empilés selon un axe perpendiculaire au plan de l'ouverture.

Avantageusement, le circuit inférieur et le circuit médian d'une part, et le circuit supérieur et le circuit médian d'autre part, sont en contact électrique l'un avec l'autre par l'intermédiaire d'au moins un ensemble de connexion, chaque ensemble de connexion comprenant un plot multicouche et une microbille de contact disposés l'un au-dessus de l'autre.

Avantageusement, la face supérieure du circuit inférieur, du circuit médian et du circuit supérieur comprennent une couche supérieure de blindage, la face inférieure du circuit médian et du circuit supérieur comprennent une couche inférieure de blindage.

Avantageusement, le circuit médian et/ou le circuit supérieur comprennent au moins un via traversant.

Avantageusement, l'enceinte comprend une membrane, l'ouverture étant ménagée dans ladite membrane, un cadre de support étant disposé entre le pourtour de la face supérieure du circuit médian et la face inférieure de la membrane.

Avantageusement, la membrane comprend au moins une rainure qui longe le cadre de support.

Avantageusement, le circuit supérieur est configuré pour être connecté ou combiné à une carte de capteur ou de qubit, le circuit inférieur étant configuré pour être connecté ou combiné respectivement à une carte de contrôle de la carte de capteur ou de qubit.

Avantageusement, un élément intercalaire est disposé entre le circuit supérieur et la carte de capteur ou de qubit, de façon à surélever la carte de capteur ou de qubit selon l'axe perpendiculaire au plan de l'ouverture de l'enceinte.

L'invention se rapporte également à un procédé de fabrication du système d'interposeur thermique précité, comprenant les étapes de :
- fabrication du circuit inférieur, du circuit supérieur et du circuit médian ;
- positionner le circuit inférieur dans l'enceinte, le circuit supérieur en-dehors de l'enceinte et le circuit médian dans ou en-dehors de l'enceinte ;
dans lequel le circuit supérieur et le circuit médian sont fabriqués par les sous-étapes suivantes :
oxydation thermique à la surface d'un substrat, de façon à obtenir une couche oxydée ;
réalisation d'un routage à un ou plusieurs niveaux supraconducteur
dépôt de plots multicouche supraconducteurs ;
dépôt d'un écran thermique et de plots conducteurs
collage, sur la face avant du circuit, d'un substrat en silicium, par l'intermédiaire d'une couche de colle ;
gravure de vias traversants ;
dépôt d'une couche de métallisation sur la surface arrière complète du circuit, sur les flancs et sur le fond de chaque via et formation de pistes de routages en face arrière du circuit par dépôt semi additif ;
formation par électrolyse de microbilles conductrices ;
décollement afin de retirer le substrat en silicium et la couche de colle.

Avantageusement, le substrat d'au moins un des circuits parmi le circuit inférieur, le circuit supérieur et le circuit médian comprend au moins un circuit intégré.

Avantageusement, le substrat d'au moins un des circuits parmi le circuit inférieur, le circuit supérieur et le circuit médian ne comprend que des composants aptes à effectuer du routage passif de signaux.

### Description des figures

D'autres caractéristiques, détails et avantages de l'invention ressortiront à la lecture de la description faite en référence aux dessins annexés donnés à titre d'exemple.
La figure 1 illustre une vue schématique du système d'interposeur thermique, selon un premier mode de réalisation.
La figure 2 illustre le couplage du cryostat et du système d'interposeur thermique selon le premier mode de réalisation.
La figure 3 illustre une vue en perspective du système d'interposeur thermique, selon le premier mode de réalisation.
La figure 4 illustre une vue schématique du système d'interposeur thermique, selon un deuxième mode de réalisation.
La figure 5 illustre le couplage du cryostat et du système d'interposeur thermique selon le deuxième mode de réalisation.
La figure 6 illustre le système d'interposeur thermique, selon le premier mode de réalisation.
La figure 7 illustre une vue en coupe transverse du système d'interposeur thermique, selon le premier mode de réalisation.
Les figures 8 à 18 illustrent les étapes du procédé de fabrication du circuit supérieur ou du circuit médian.

### Description détaillée

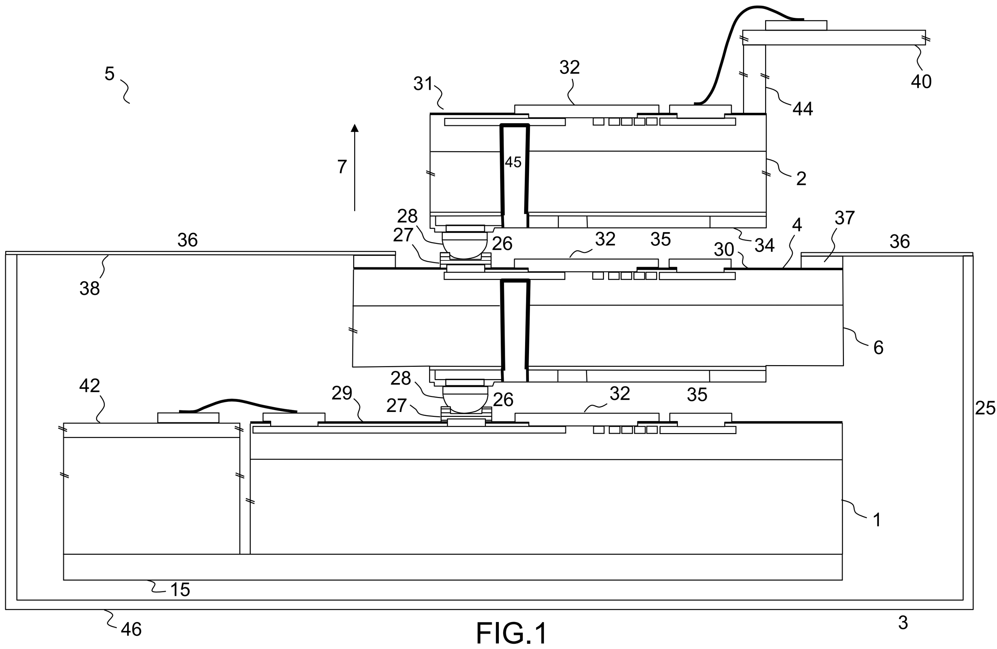

Le système selon un premier mode de réalisation de l'invention est décrit en lien avec la figure 1 ; ce mode de réalisation est particulièrement adapté à une application « en champ libre », dans laquelle la carte supérieure 40 contient une puce de capteur, en particulier un détecteur à basse température, ou tout autre dispositif devant fonctionner à très basse température, tel qu'un circuit de qubits. Dans tous les cas, cette puce sera ci-après dénommée « puce de capteur ».

La carte supérieure 40 est connectée à une carte inférieure 42 contenant une puce de contrôle. Dans la présente description, il est considéré, à titre de simplification, que la carte inférieure 42 ne commande qu'une seule carte supérieure 40. Dans la pratique, la carte inférieure 42 comprend l'électronique nécessaire pour commander et pour lire une pluralité de puces de capteur (également appelées détecteurs).

La puce de contrôle sur la carte inférieure 42 peut être mécaniquement et électriquement liée à un circuit inférieur 1, ou bien constituer directement ce circuit inférieur 1, selon les configurations souhaitées. De même, la puce de capteur ou qubit sur la carte supérieure 40 peut être mécaniquement et électriquement liée à un circuit supérieur 2, ou constituer directement ce circuit supérieur 2 (auquel cas la carte supérieure 40 est inutile et peut être supprimée).

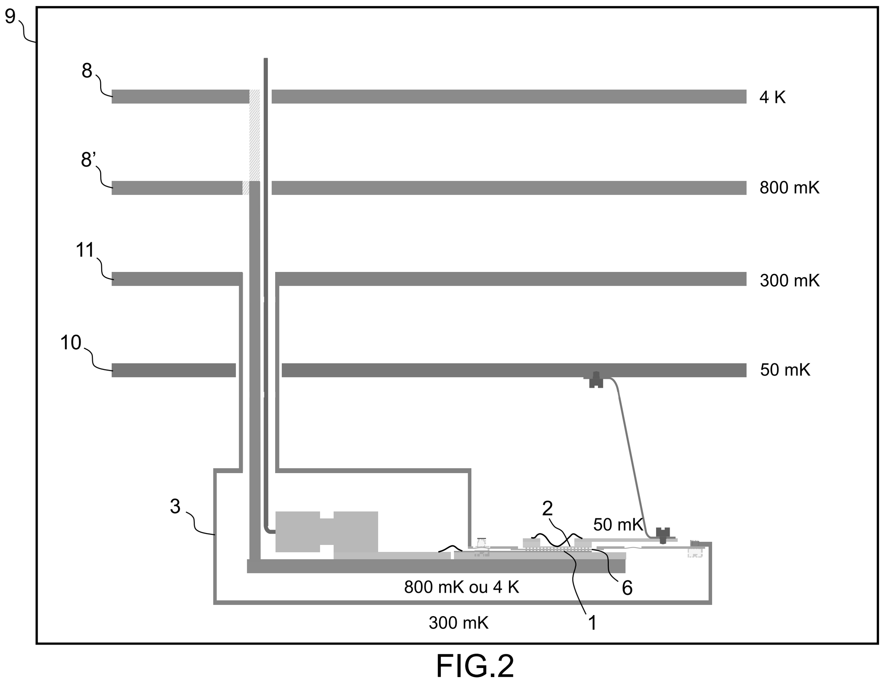

Le circuit inférieur 1 est refroidi par un premier étage thermique (8, 8') d'un cryostat 9, et le circuit supérieur 2 est refroidi par un deuxième étage thermique 10 du cryostat 9 (cf. figure 2, qui représente une vue schématique du cryostat à dilution et du système d'interposeur thermique selon l'invention).

Un circuit intégré médian 6 est disposé entre le circuit supérieur 2 et le circuit inférieur 1, de façon à ce que les trois circuits puissent être empilés les uns au-dessus des autres, tout en offrant une excellente isolation thermique entre le circuit supérieur 2 et le circuit inférieur 1, et une connexion électrique entre le circuit supérieur 2 et le circuit inférieur 1, qui permet d'avoir une interconnexion électrique entre la carte supérieure 40 et la carte inférieure 42. Ce circuit médian 6 peut être un simple circuit d'interfaçage passif contenant uniquement des éléments d'interconnexion (pistes électriques, via traversants, etc.), ou bien il peut recevoir des fonctions électroniques actives telles que celle de multiplexage ou des éléments passifs tels que des résistances, des inductances ou des capacités ou toute combinaison de ces composants R, L, C.

Le circuit inférieur 1 et le circuit médian 6 sont disposés dans une enceinte 3 qui est elle-même refroidie par un troisième étage thermique 11 du cryostat 9. L'enceinte 3 doit être faite d'un matériau bon conducteur thermique, car elle thermalise (c.à.d. couple thermiquement) le circuit médian 6.

La carte supérieure 40 peut être surélevée par un élément intercalaire 44, par rapport à un circuit supérieur 2, ou être directement reliée au circuit supérieur 2, selon les configurations souhaitées.

La surélévation de la carte supérieure 40 permet de placer la carte à distance des pièces de l'enceinte, pour ne pas perturber l'isolation thermique entre la carte et le circuit supérieurs (40 et 2) d'une part, tous deux reliés thermiquement au deuxième étage thermique, et d'autre part le circuit médian relié au troisième étage thermique par l'intermédiaire de l'enceinte 3. En effet, la hauteur totale du circuit supérieur 2 est extrêmement réduite.

L'invention est décrite avec trois circuits, couplés à trois étages thermiques. Elle peut être généralisée à un nombre supérieur de circuits, ou à seulement deux circuits (auquel cas l'enceinte 3 peut être supprimée).

Avantageusement, l'enceinte 3 peut comprendre du cuivre doré (cuivre recouvert d'une fine couche d'or). Le cuivre et l'or sont de très bons conducteurs thermiques. Par ailleurs, la couche d'or ne s'oxyde pas, ce qui permet de maintenir les performances thermiques sur le long terme. La couche d'or permet également d'augmenter les réflexions des rayons infra-rouges issus d'éléments plus chaud placés à l'intérieur (premier mode de réalisation) ou à l'extérieur (deuxième mode de réalisation) de l'enceinte 3.

Le premier étage thermique 8, le deuxième étage thermique 10 et le troisième étage thermique 11 sont, par exemple, les étages thermiques d'un cryostat à dilution. Le premier étage thermique 8 peut avoir une température comprise entre 1 K et 4 K (ou une température de 800 mK, cf. premier étage 8' sur la figure 2), le deuxième étage thermique 10 peut avoir une température égale à 50 mK, et le troisième étage thermique 11 peut avoir une température égale à 300 mK. Ces valeurs ne sont toutefois pas limitatives.

Il est à noter que la disposition du circuit inférieur 1, du circuit médian 6 et du circuit supérieur 2 est indépendante de l'agencement des étages thermiques du cryostat.

L'enceinte 3 comprend une ouverture 4. Le circuit médian 6 est disposé de telle manière qu'il ferme l'ouverture 4. Le circuit inférieur 1, le circuit supérieur 2 et le circuit médian 6 sont empilés selon un axe 7 perpendiculaire au plan de l'ouverture 4. Ainsi, il est fait totalement obstacle au rayonnement thermique infrarouge généré par les éléments situés du côté « chaud » de l'enceinte 3 (carte, circuits, etc.) qui, sinon, viendraient réchauffer les éléments situés côté « froid » de l'enceinte.

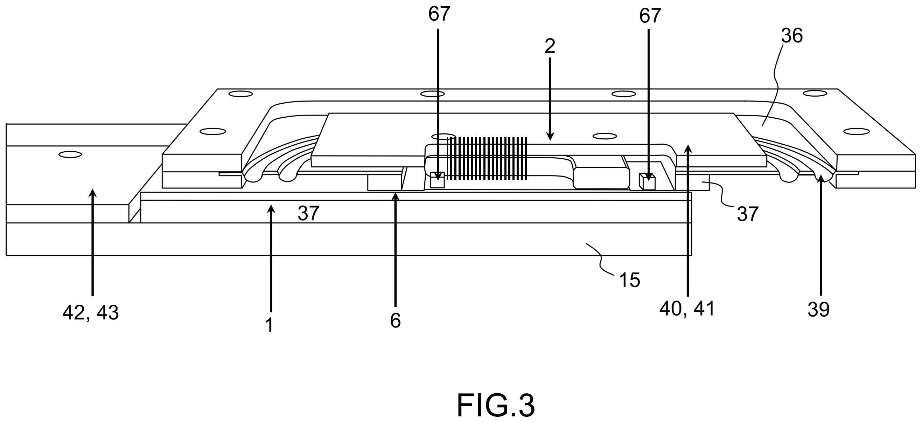

La face supérieure 30 du circuit médian 6 bouche ainsi l'ouverture 4. Avantageusement, un cadre de support 37 est disposé entre la face supérieure 30 du circuit médian 6 et le pourtour de l'ouverture 4, comme l'illustre la figure 3, qui représente une vue agrandie en coupe de l'interposeur. Le cadre de support 37 permet d'apporter une tenue mécanique rigide entre le circuit médian 6 et la membrane souple 36 de l'enceinte 3.

L'enceinte 3 peut prendre la forme d'un pavé comprenant une base plate 46, quatre façades verticales 25, et une partie supérieure 36, dans laquelle se trouve l'ouverture 4.

Le système selon l'invention apporte ainsi une efficacité d'isolation thermique qui est bien meilleure à celle d'une architecture classique qui comporte des connexions filaires longues (pour obtenir un isolement thermique suffisant) entre chaque étage du cryostat. Cette efficacité d'isolation permet de réaliser des systèmes consommant moins d'énergie de refroidissement à nombre de détecteurs constant ou, à iso-énergie, d'augmenter le nombre de détecteurs. L'isolation thermique obtenue est d'autant plus efficace que la température des circuits intégrés du système est basse, la conduction thermique des interfaces isolantes diminuant très rapidement avec la température.

De plus, l'approche 3D matricielle (où les circuits sont superposés et interconnectés verticalement par un réseau matriciel de billes) permet d'obtenir un traitement identique et en parallèle de toutes les voies (détecteurs ou qubits), ce qui réduit la longueur et l'encombrement des interconnexions et est donc favorable aux performances, à l'uniformité de ces performances, et à la densité d'intégration des détecteurs ou qubits qui peut être atteinte.

Avantageusement, la partie supérieure de l'enceinte 3 est faite d'une membrane 36. Par membrane, on entend une plaque souple de faible épaisseur, en particulier ayant une épaisseur inférieure à celle de la base ou à celle des façades. Ainsi, l'épaisseur réduite de la membrane permet de limiter l'encombrement, en hauteur, du système, et procure à la membrane la souplesse qui lui permet d'absorber les mouvements différentiels entre pièces.

La membrane 36 peut comprendre du cupro-bérylium, qui offre souplesse et haute résistance mécanique. Ce matériau est beaucoup plus résistant et dur que le cuivre pur, avec une limite d'élasticité élevée (jusqu'à 1400 MPa après traitement thermique), ce qui le rend idéal pour des pièces soumises à de fortes contraintes. Par ailleurs, il possède une bonne conductivité thermique.

Comme l'illustre la figure 3, la membrane 36 peut comprendre au moins une rainure 39 qui longe le cadre de support 37, afin d'absorber les jeux mécaniques se produisant lors des phases de refroidissement ou de réchauffage du système, et provenant des différences de rétreint entre les différentes pièces et matériaux du dispositif. Il s'agit en particulier d'éviter l'arrachement au niveau des collages entre la face inférieure de la membrane et le cadre de support 37, et/ou entre le cadre de support 37 et la face supérieure du circuit médian, ou la casse des circuits eux-mêmes. La rainure 39 n'est pas indispensable, sous réserve, dans ce cas, que la membrane soit faite d'un matériau suffisamment souple pour compenser les différences de retreint. Des éléments de chauffage et de mesure de la température 67 sont disposés au niveau du circuit médian 6 et du circuit supérieur 2.

Le circuit inférieur 1, le circuit médian 6 et le circuit supérieur 2 sont composés d'au moins un substrat, qui fait office de support, généralement en silicium, et d'au moins une couche de routage, en métal ou matériau supraconducteur, et disposée sur le substrat. Les circuits peuvent éventuellement comporter en outre des composants électroniques intégrés, tels que transistors et des éléments passifs (R, L, C).

La connexion électrique entre le circuit inférieur 1 et le circuit médian 6 se fait par l'intermédiaire d'au moins un ensemble de connexion 26, chaque ensemble de connexion 26 comprenant un plot multicouche 27 et une microbille de contact 28 disposés l'un au-dessus de l'autre.

Le plot multicouche 27 peut être une structure supraconductrice et thermiquement très isolante, telle que celle décrite dans l'article de [Sauvageot]. Dans cet article, le circuit multicouche comprend une alternance de couches de nitrure de titane et de niobium. L'isolation thermique est obtenue grâce à une désadaptation acoustique entre les couches. L'épaisseur est très faible (de l'ordre du micron), avec une impédance électrique très faible grâce à l'utilisation exclusive de matériaux supraconducteurs. De préférence, la microbille de contact est en indium ou étain, afin de bénéficier de la transition supraconductrice qui contribue à l'isolation thermique entre les circuits et réduit la résistance électrique.

La figure 1 ne représente qu'un seul ensemble de connexion 26 entre le circuit inférieur 1 et le circuit médian 6. En pratique, il peut y avoir une pluralité d'ensembles de connexion 26, notamment autant d'ensembles de connexion 26 qu'il y a de cellules de capteur ou de qubits.

De la même manière, la connexion électrique entre le circuit médian 6 et le circuit supérieur 2 se fait par l'intermédiaire d'au moins un ensemble de connexion 26, chaque ensemble de connexion 26 comprenant un plot multicouche 27 et une microbille de contact 28 disposés l'un au-dessus de l'autre.

Le système selon l'invention est ainsi mécaniquement robuste et moins sensibles aux vibrations que des systèmes reliés par des câbles flexibles.

De plus, la densité élevée de connexions (un pas de 20 µm peut être obtenu pour les ensembles de connexions 26) entre les puces capteurs ou qubits et les puces de contrôle, rendue possible par la présence des ensembles de connexion, permet de minimiser la distance qui sépare chaque capteur ou qubit de son électronique de contrôle, et permet ainsi d'augmenter la bande passante du système.

Le système selon l'invention, en positionnant les fonctions électroniques des puces de contrôle au plus proche des capteurs ou qubits, permet d'obtenir un signal de sortie des fonctions électroniques de plus grande amplitude et donc un rapport signal sur bruit plus important. Il augmente également les possibilités de multiplexage des signaux et permet la mise en œuvre de fonctions d'amplification plus performantes.

Avantageusement, la face supérieure 29 du circuit inférieur 1, la face supérieure 30 du circuit médian 6 et/ou la face supérieure 31 du circuit supérieur 2 comprennent une couche supérieure de blindage 32. De même, la face inférieure 33 du circuit médian 6 et/ou la face inférieure 34 du circuit supérieur 2 comprennent une couche supérieure de blindage 35.

Les couches de blindage réfléchissent les émissions infrarouges parasites provenant des parties plus chaudes, permettent un drainage efficace de la chaleur vers les étages thermiques du cryostat à dilution, et protègent l'intérieur des circuits du bruit électromagnétique parasite. Ils sont avantageusement conçus en or ou en cuivre. Les couches de blindage sont avantageusement disposées sur la majeure partie de la face supérieure ou de la face inférieure.

Le circuit médian 6 et/ou le circuit supérieur 2 sont avantageusement traversés, sur leur épaisseur (selon l'axe 7 perpendiculaire au plan de l'ouverture), par au moins un via traversant 45. Le via traversant (ou through silicon via (TSV) en anglais) 45 permet d'établir une connexion électrique entre la face inférieure 33 du circuit médian 6 et la face supérieure du circuit médian 6, et permet aussi d'établir une connexion électrique entre la face inférieure 35 du circuit supérieur 2 et la face supérieure 31 du circuit supérieur 2, en reliant les pistes situées à différents niveaux.

Dans un exemple de mise en œuvre du système, le substrat (en silicium) du circuit inférieur a une épaisseur de 725 µm, et le substrat des circuits médian et supérieur a une épaisseur de 120 µm ; la distance entre les couches de blindage des faces supérieure et inférieure est comprise entre 40 et 50 µm ; les vias traversants ont un diamètre de 60 µm.

Les vias traversant le substrat peuvent avantageusement être métallisés avec un matériau supraconducteur, sinon plus classiquement avec du cuivre.

La compacité obtenue grâce à ce dispositif permet une miniaturisation extrême des systèmes de détections. En effet, le passage d'un système de connexions par fils ou nappes à un système à microbilles permet de réduire la longueur des interconnexions de la dizaine de centimètres à la dizaine de µm. Cette miniaturisation des dimensions des interconnexions 3D entre les puces de détecteurs et les puces de contrôles ou d'amplification permet une réduction des éléments parasites (R, L, C). De plus, les interconnexions utilisées rendent le système moins sensible aux perturbations électromagnétiques.

La version dite « champ libre », illustrée par la figure 1, laisse une grande place pour disposer en regard des sources de stimulation et caractériser le comportement des détecteurs (puces de capteurs).

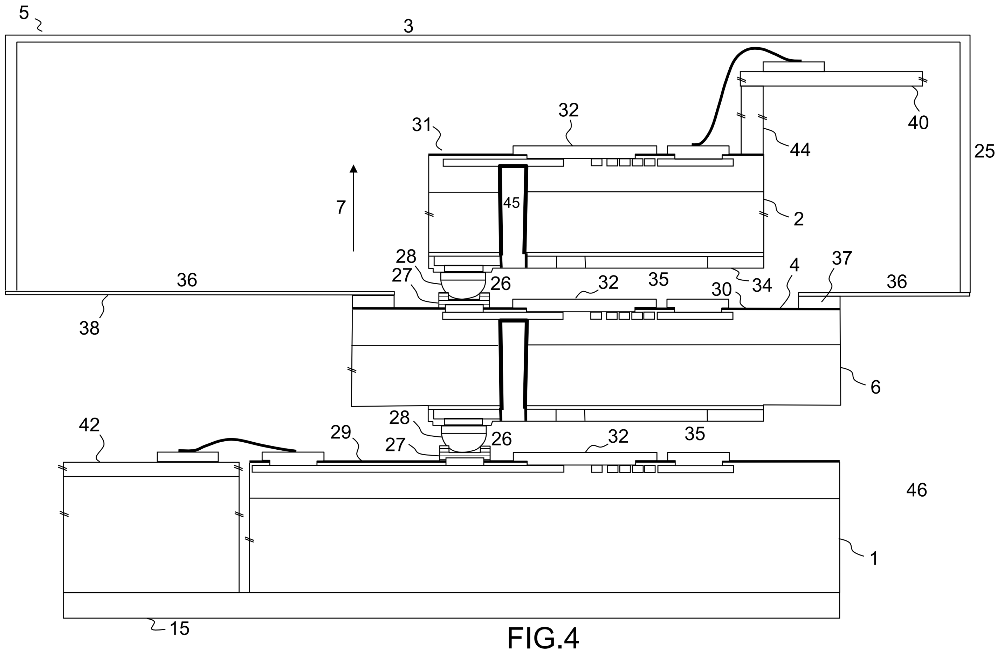

La figure 4 illustre un deuxième mode de réalisation du système selon l'invention, dit « en champ clos ». L'empilement du circuit inférieur 1, du circuit médian 6 et du circuit supérieur 2 est identique à l'empilement présenté en lien avec le premier mode de réalisation de la figure 1.

A la différence du premier mode de réalisation, pour lequel l'enceinte entoure les cartes et circuits inférieurs et le circuit médian, le deuxième mode de réalisation est caractérisé par le fait que l'enceinte entoure uniquement les cartes et circuit supérieurs.

Le système d'interposeur thermique selon le deuxième mode de réalisation comprend un circuit intégré inférieur 1 et un circuit intégré supérieur 2. Le circuit inférieur 1 est configuré pour être couplé thermiquement à un premier étage thermique 8 d'un cryostat 9, et le circuit supérieur 2 est configuré pour être couplé thermiquement à un deuxième étage thermique 10 du cryostat 9.

Le circuit supérieur 1 est positionné dans une enceinte 3 qui comprend une ouverture 4. L'enceinte 3 est couplée thermiquement à un troisième étage thermique 11 du cryostat 9. Un circuit intégré médian 6 est disposé à l'extérieur de l'enceinte 3, au niveau de ladite ouverture 4, de façon à ce que le circuit médian 6 ferme l'ouverture 4.

Le circuit inférieur 1, le circuit supérieur 2 et le circuit médian 6 sont empilés selon un axe 7 perpendiculaire au plan de l'ouverture 4.

Le cadre de support 37 est disposé entre la face inférieure 38 de l'enceinte 3 et la face supérieure 30 du circuit médian.

Il peut être noté que dans la présente demande, les termes « inférieur », « supérieur », « horizontal » ou encore « vertical » font référence à la disposition des éléments dans les figures ; ils n'excluent donc pas une orientation différente.

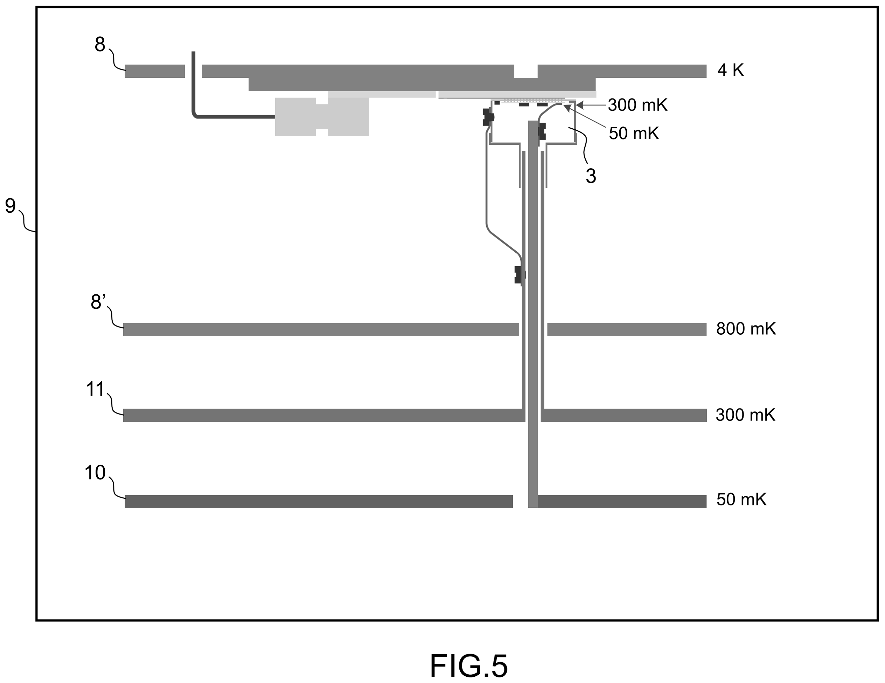

La figure 5 illustre schématiquement le couplage entre les étages du cryostat et le système d'interposeur dans le mode de réalisation en champ clos. Sur cette figure les circuits sont assemblés comme précédemment, mais l'ensemble du système est ensuite retourné afin d'être fixé sur la face inférieure de l'étage thermique 8 ; le circuit dit supérieur est donc finalement situé plus bas que le circuit dit inférieur.

Dans le mode de réalisation en champ clos, le circuit dit supérieur peut être thermalisé par le premier étage thermique 10 d'un cryostat 9, dont la température peut typiquement être de 50 mK.

Ainsi, l'environnement à l'intérieur de l'enceinte 3 est à 50 mK, ce qui peut être adapté pour l'intégration de puces de qubits, ou de tout circuit basse température. L'architecture est compatible avec une mise à l'échelle pour des systèmes de calcul quantique à grande échelle (i.e. impliquant un grand nombre de qubits) (« large scale quantum computing » selon la terminologie anglo-saxonne).

De plus, ce mode de réalisation est également adapté pour une intégration dans un satellite.

Les différents modes de réalisation décrits en lien avec la version « champ libre » de l'invention s'appliquent également à la version « champ clos » ; elles ne sont donc pas décrites à nouveau.

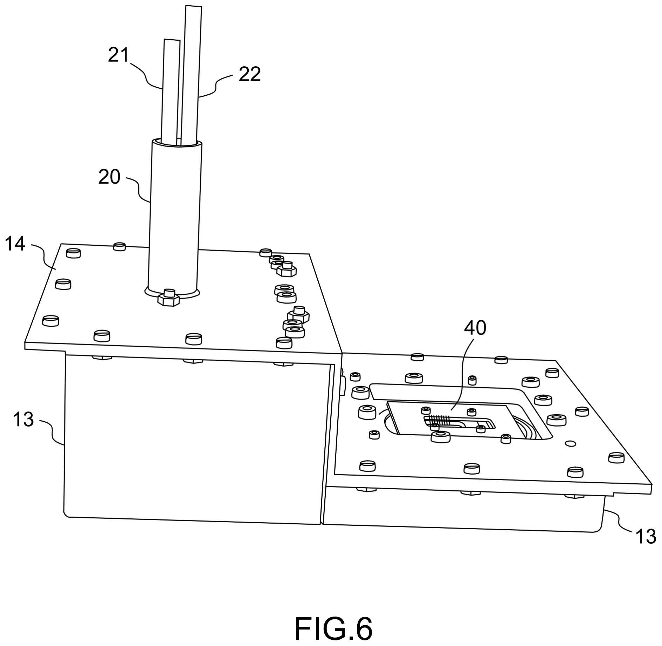

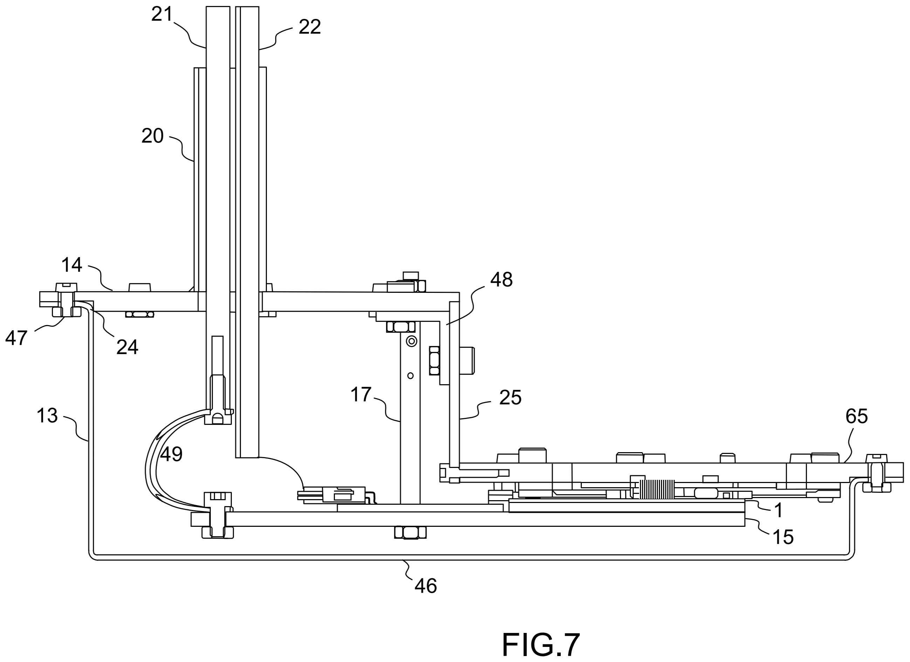

Les figures 6 et 7 illustrent un mode de réalisation particulièrement avantageux du couplage thermique du circuit inférieur avec un premier étage thermique d'un cryostat, dans une configuration « champ libre ». L'homme du métier saura, sans difficulté, transposer l'agencement à la configuration « champ clos ».

Sur les figures 6 et 7, l'enceinte 3 comprend une partie basse 12 et une partie haute 13 adjacentes l'une à l'autre. La figure 3 représente une vue détaillée et en coupe de la partie basse 12. Le circuit inférieur 1 et le circuit médian 6 sont donc disposés à l'intérieur de la partie basse 12, comme cela est également visible sur la figure 1.

Comme cela est visible sur la figure 7, la partie haute 13 comprend une base 14 ainsi qu'une façade verticale 25, tandis que la partie basse 12 comprend une base 65. Un couvercle amovible 46 avec rebords verticaux, commun aux parties haute et basse, permet de protéger l'extérieur du rayonnement infrarouge émis à l'intérieur de l'enceinte close 3, ou au contraire une fois retiré d'accéder à l'intérieur lors de l'installation ou de la maintenance. Des moyens de fixation mécanique 47, tels que des écrous et boulons, permettent de fixer le couvercle 46 à la base 14 et 65 des parties haute et basse.

Selon un mode de réalisation illustré par la figure 7, le moyen de fixation mécanique 48 permet de maintenir ensemble la façade verticale 25 contre la base 14 d'une part, et contre la base de la partie basse 65 d'autre part.

L'ensemble composé de la base 14 de la partie haute, de la façade 25, et de la base 65 de la partie basse est fixe, et accrochée au plateau du troisième étage thermique 11 du cryostat (par exemple à une température de 300 mK).

La base 14 peut avoir une épaisseur réduite dans la zone de fixation du moyen de fixation mécanique 47. Avantageusement, le repliement à 90° des parties verticales du couvercle 46 respecte un rayon de courbure (déterminé notamment par le matériau utilisé), de façon à avoir un interstice (ou gorge) 24 à la jonction entre la base 14 et le couvercle 46, afin de piéger les rayonnements infra-rouges. Ainsi, les rayonnements infra-rouges émis à l'intérieur de l'enceinte ne chauffent ni l'environnement à très basse température environnant ni le circuit supérieur.

Les moyens de fixation mécanique peuvent également comprendre une équerre 48 fixée avec des vis ou boulons/écrous, afin de fixer le couvercle 14 et la façade verticale 25 à angle droit.

Le circuit inférieur 1 est disposé sur une plaque de support 15 qui s'étend dans la partie haute 13 et dans la partie basse 12. Un ensemble d'au moins une colonne (17, 18, 19) s'étend sur la hauteur de la partie haute 13, entre la base14 et la plaque de support 15.

L'ensemble de colonnes a une fonction de tenue mécanique, dans la mesure où elle permet de maintenir la plaque de support 15 à distance de la base 14 et du couvercle 46 pour éviter un court-circuit thermique, la plaque 15 étant à une température supérieure. Les colonnes possèdent une résistance thermique élevée, afin de ne pas constituer elles-mêmes un court-circuit thermique entre la plaque de support 15 et la base 14. Avantageusement, l'ensemble de colonnes comprend trois colonnes (17, 18, 19) réparties sensiblement à équidistance l'une de l'autre. Sur la figure 5, une seule colonne 17 est représentée. Une deuxième colonne 18 peut être présente devant la colonne 17 (selon l'axe orthogonal au plan de la figure), et une troisième colonne 19 peut être présente à proximité du tube principal 20. Cette configuration permet de régler le parallélisme entre la plaque de support 15 et la base de la partie basse 65, ces deux éléments n'étant reliés que par une membrane souple.

Les colonnes de l'ensemble de colonnes peuvent être fixées au couvercle 14 et à la plaque de support 15 par des fixations amovibles du type écrou/boulon, ou tout autre moyen équivalent connu de l'homme du métier.

La hauteur de la partie haute 13, selon l'axe perpendiculaire au plan de l'ouverture, est déterminée notamment en fonction de la résistance thermique des colonnes, et de leur diamètre. Les colonnes peuvent avantageusement être en PEEK (polyétheréthercétone), qui conduit très peu la chaleur.

Selon ce mode de réalisation, le circuit inférieur 1 est couplé thermiquement au premier étage thermique 8 d'un cryostat 9 par l'intermédiaire de la plaque de support 15 et d'un premier tube interne 21, qui traverse sans contact la base 14. L'extrémité du premier tube interne 21 et la plaque de support 15 sont thermiquement couplées par l'intermédiaire d'un flexible 49.

Le premier tube interne 21 peut être logé dans un tube principal 20, avec un deuxième tube interne 22, configuré pour contenir au moins un conducteur électrique 23 pour l'émission/réception de signaux électriques entre l'extérieur de l'interposeur et la carte inférieure 42.

Les tubes internes 21 et 22 sont isolés vis-à-vis du tube principal 20, afin de garantir une isolation thermique entre les tubes. Le tube principal 20 (refroidi typiquement à 300 mK) intercepte le rayonnement infra-rouge émis par les tubes internes 21 et 22 (refroidis typiquement à 800 mK ou 4 K) afin que celui-ci ne réchauffe pas l'environnement extérieur (refroidi typiquement à 50 mK).

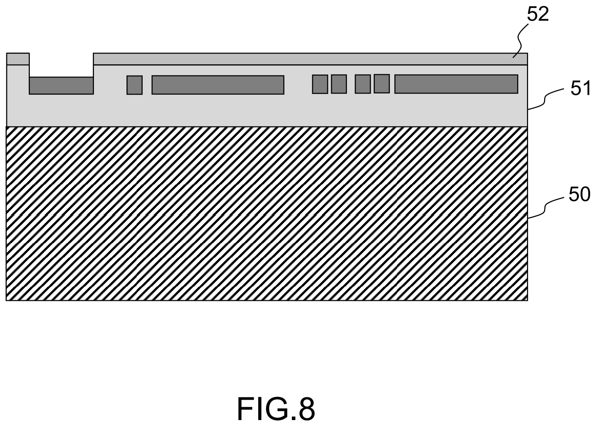

Les figures 8 à 16 illustrent les différentes étapes de fabrication du circuit (indifféremment inférieur, médian ou supérieur).

Dans une première étape, illustrée par la figure 8, une oxydation thermique est effectuée à la surface d'un substrat en silicium 50 (face avant, épaisseur 725 µm), de façon à obtenir une couche oxydée 51 d'épaisseur 500 nm. Une première couche de métal (supraconducteur et nitrure de titane) 52 est ensuite déposée et structurée, d'épaisseur 540 nm, et permet de router les signaux.

Les circuits inférieur, médian et supérieur peuvent contenir soit du simple routage passif, soit en outre des fonctions électroniques, pour une application donnée. Dans ce dernier cas, le procédé de fabrication ne part pas d'un substrat vierge 50, mais d'un circuit intégré déjà équipé de fonctions électroniques, et pouvant être fabriqué dans n'importe quelle fonderie industrielle.

Une passivation est effectuée par dépôt de matériaux diélectrique à 400° C, typiquement des oxydes et nitrures de silicium (épaisseur 0,2 à 2 µm) puis elle est ouverte 53 par lithographie et gravure au-dessus des plots de contact

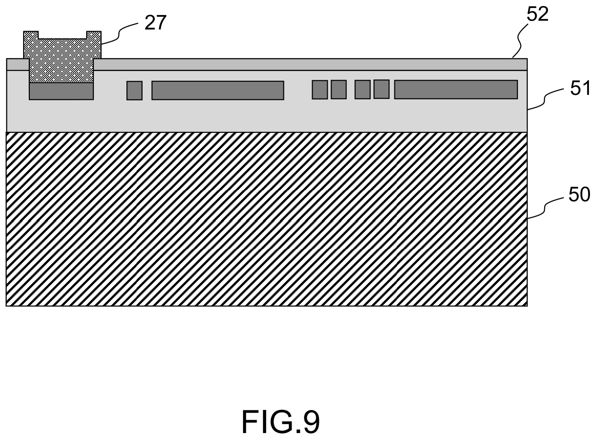

Sur la figure 9, un plot multicouche 27 (décrit dans [Sauvageot]) est déposé sur le dispositif (face avant) puis défini par photolithographie, gravure et délaquage ou stripping.

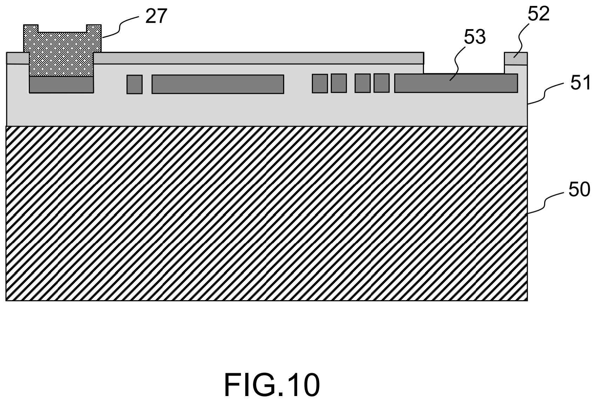

Sur la figure 10, une structuration est effectuée de façon à aménager un emplacement 53 pour un plot (face avant).

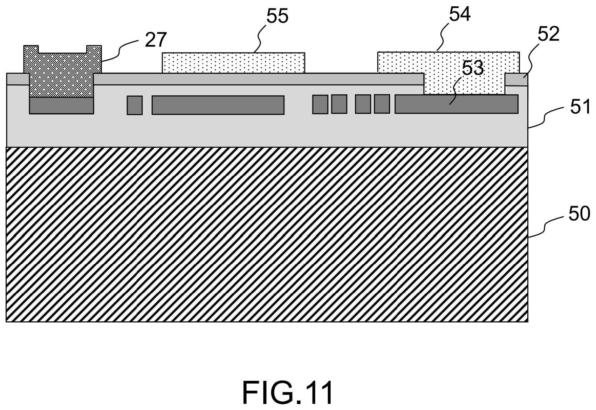

Sur la figure 11, un dépôt de titane et d'or 54 d'épaisseur 0,2 à 5 µm est déposé et structuré, de façon à thermaliser (par routage résistif) l'interposeur. Il se comporte comme un miroir à photons 55 (écran thermique), avec un espacement de l'ordre de 50 à 100 µm entre les pistes.

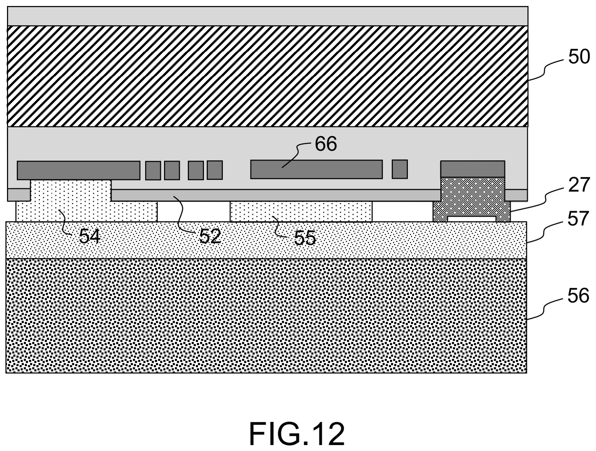

L'ensemble est ensuite retourné, et collé (figure 12) par sa face avant sur un substrat en silicium 56, par l'intermédiaire d'une couche de colle 57 (couche de colle d'épaisseur 20 µm, amincissement du substrat en face arrière de 725 à 120 µm, et dépôt d'un oxyde de silicium appelé masque dur de 1 µm par la technique de dépôt chimique en phase vapeur assisté par plasma -PECVD en anglais- à 150° C).

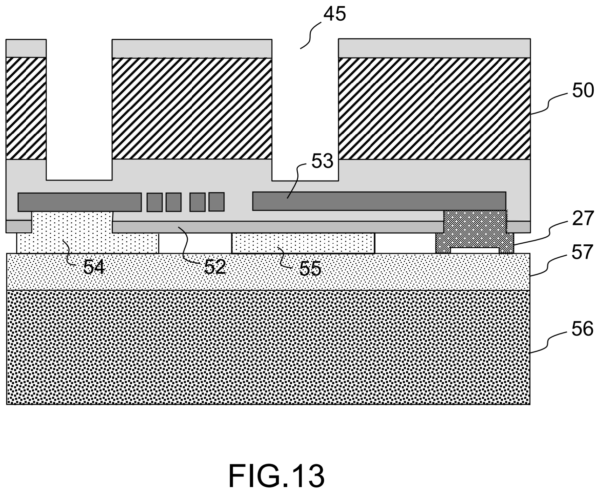

Sur la figure 13, des vias traversants 45 sont créés par lithographie et gravure profonde du silicium. Les vias traversants permettent de router les signaux à travers le substrat. La forme géométrique des vias peut être définie par lithographie. La gravure peut être effectuée par gravure du masque dur, gravure DRIE (« Deep Reactive Ion Etching » pour gravure ionique réactive profonde), gravure partielle PMD puis par « stripping ».

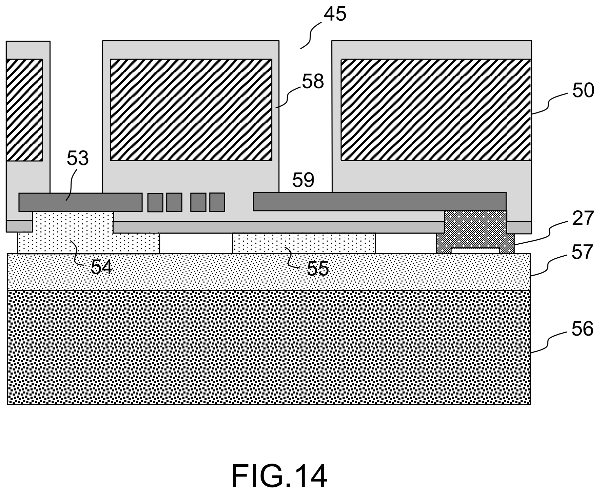

La figure 14 illustre le dépôt optionnel d'un isolant 58 (oxyde de silicium) par dépôt chimique en phase vapeur assisté par plasma (PECVD), à une température de 180° C sur le fond et les flancs du TSV. Le fond du TSV 59 fait ensuite l'objet d'une dernière gravure (appelée « etch back ») afin de pouvoir retirer le dernier oxyde 58 du fond du TSV et ainsi assurer un bon contact du futur dépôt métallique 60 avec la couche de routage 66.

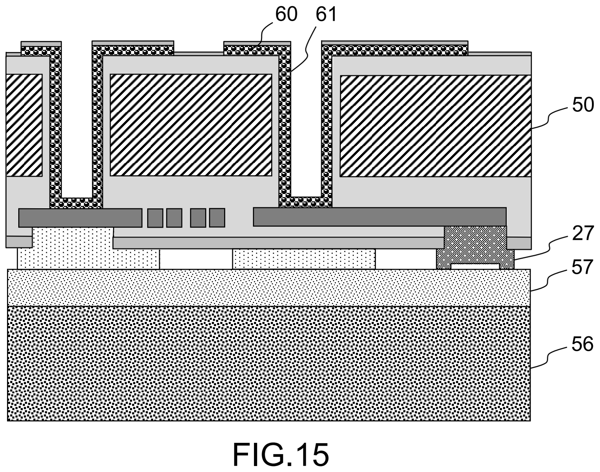

Sur la figure 15, une couche de métallisation 60, de préférence du nitrure de titane, est déposée (dépôt chimique en phase vapeur, à 200° C), sur une épaisseur comprise entre 50 et 100 nm, sur les flancs de chaque via, sur le fond et en surface. Cette couche 60 peut également être constituée de cuivre de 200 nm à 5 µm d'épaisseur déposé par électrolyse (Fig. 15).

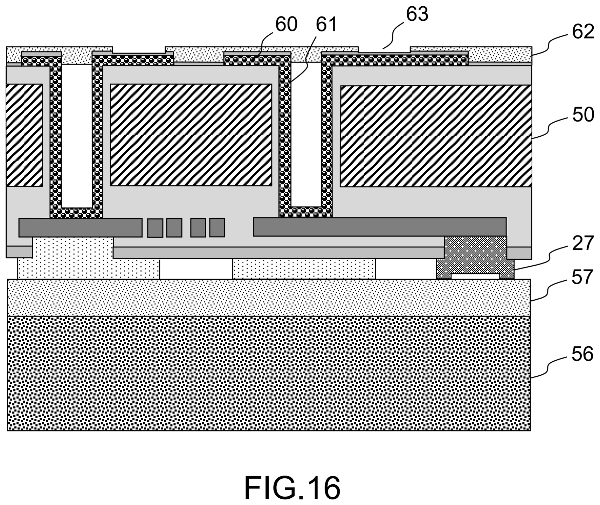

La figure 16 illustre le dépôt d'une couche de polymères 62 d'une épaisseur comprise entre 1 et 15 µm, à basse température. Une étape de lithographie du polymère 62, permet de réserver les emplacements 63 pour les « bumps » (microbille conductrice).

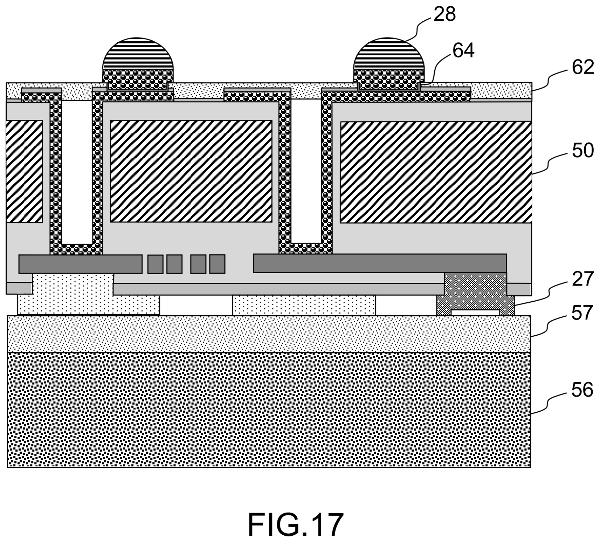

Sur la figure 17, les couches de barrière/germination 64 respectivement en titane 100 nm et cuivre 400 nm sont déposées. La microbille de contact 28 est formée grâce au procédé semi-additif par dépôt électrochimique de cuivre, nickel et d'un alliage étain/argent, avec une épaisseur d'environ 50 µm (couche de départ et microbille). La couche de départ 64 est ensuite gravée après le retrait de la résine

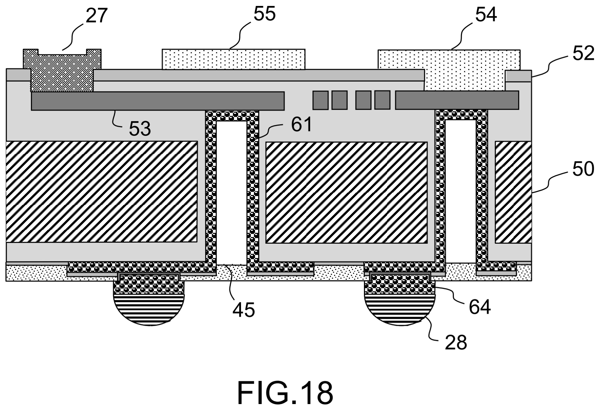

La structure finale est illustrée par la figure 18. Une étape de décollement permet de retirer le substrat en silicium 56 et la couche de colle 57.

### Documents cités

[Sauvageot] « New way to manage high density signal connections and the small power of sub-K cryo-generators », Sauvageot et al., 2022 IEEE 15th Workshop on Low Temperature Electronics (WOLTE)

## Revendications

1. Système d'interposeur thermique (5) comprenant un circuit intégré dit inférieur (1) et un circuit intégré dit supérieur (2), le circuit inférieur (1) étant configuré pour être couplé thermiquement à un premier étage thermique (8) d'un cryostat (9), le circuit supérieur (2) étant configuré pour être couplé thermiquement à un deuxième étage thermique (10) du cryostat (9), le circuit inférieur (1) étant positionné dans une enceinte (3) comprenant une ouverture (4), l'enceinte (3) étant configurée pour être couplée thermiquement à un troisième étage thermique (11) du cryostat (9), le système (5) comprenant également un circuit intégré dit médian (6) disposé dans l'enceinte (3), au niveau de ladite ouverture (4) de façon à ce que le circuit médian (6) ferme l'ouverture (4), et dans lequel le circuit inférieur (1), le circuit supérieur (2) et le circuit médian (6) sont empilés selon un axe (7) perpendiculaire au plan de l'ouverture (4).

2. Système selon la revendication 1, dans lequel, l'enceinte (3) comprend une partie basse (12) ayant une base de partie basse (65) et une partie haute (13) ayant une base de partie haute (14), la partie basse (12) et la partie haute (13) étant adjacentes l'une par rapport à l'autre, le circuit inférieur (1) et le circuit médian (6) étant disposés dans la partie basse (12), la partie haute (13) ayant une hauteur supérieure à la hauteur de la partie basse (12), un couvercle (46) refermant les la partie haute (13) et la partie basse (12), le circuit inférieur (1) étant disposé sur une plaque de support (15) qui s'étend dans la partie haute (13) et dans la partie basse (12), dans lequel un ensemble d'au moins une colonne (17, 18, 19) s'étend sur la hauteur de la partie haute (13), entre la plaque de support (15) et la base de la partie haute (14).

3. Système selon la revendication 2, dans lequel l'ensemble d'au moins une colonne (16) comprend trois colonnes (17, 18, 19) réparties sensiblement à équidistance l'une de l'autre.

4. Système selon la revendication 3, dans lequel un tube principal (20) débouche sur le couvercle (14), le tube principal (20) comprenant en son sein un premier tube interne (21) configuré pour coupler thermiquement le circuit inférieur (1) au premier étage thermique (8), et un deuxième tube interne (22) configuré pour contenir au moins un conducteur électrique (23) pour l'émission/réception de signaux électriques.

5. Système selon l'une des revendications 2 à 4, dans lequel un piège à rayonnements infra-rouges (24) est aménagé à la jonction entre le couvercle (14) et une façade (25) de la partie haute (13).

6. Système d'interposeur thermique (5) comprenant un circuit intégré dit inférieur (1) et un circuit intégré dit supérieur (2), le circuit inférieur (1) étant configuré pour être couplé thermiquement à un premier étage thermique (8) d'un cryostat (9), le circuit supérieur (2) étant configuré pour être couplé thermiquement à un deuxième étage thermique (10) du cryostat (9), le circuit supérieur (1) étant positionné dans une enceinte (3) comprenant une ouverture (4), l'enceinte (3) étant configurée pour être couplée thermiquement à un troisième étage thermique (11) du cryostat (9), le système (5) comprenant également un circuit intégré dit médian (6) disposé à l'extérieur de l'enceinte (3), au niveau de ladite ouverture (4), de façon à ce que le circuit médian (6) ferme l'ouverture (4), et dans lequel le circuit inférieur (1), le circuit supérieur (2) et le circuit médian (6) sont empilés selon un axe (7) perpendiculaire au plan de l'ouverture (4).

7. Système selon l'une des revendications précédentes, dans lequel le circuit inférieur (1) et le circuit médian (6) d'une part, et le circuit supérieur (2) et le circuit médian (6) d'autre part, sont en contact électrique l'un avec l'autre par l'intermédiaire d'au moins un ensemble de connexion (26), chaque ensemble de connexion (26) comprenant un plot multicouche (27) et une microbille de contact (28) disposés l'un au-dessus de l'autre.

8. Système selon l'une des revendications précédentes, dans lequel la face supérieure (29, 30, 31) du circuit inférieur (1), du circuit médian (6) et du circuit supérieur (2) comprennent une couche supérieure de blindage (32), la face inférieure (33, 34) du circuit médian et du circuit supérieur comprennent une couche inférieure de blindage (35).

9. Système selon l'une des revendications précédentes, dans lequel le circuit médian (6) et/ou le circuit supérieur (2) comprennent au moins un via traversant (45).

10. Système selon l'une des revendications précédentes, dans lequel l'enceinte (3) comprend une membrane (36), l'ouverture (4) étant ménagée dans ladite membrane (36), un cadre de support (37) étant disposé entre le pourtour de la face supérieure du circuit médian (30) et la face inférieure de la membrane (38).

11. Système selon la revendication 10, dans lequel la membrane (36) comprend au moins une rainure (39) qui longe le cadre de support (37).

12. Système selon l'une des revendications précédentes, dans lequel le circuit supérieur (2) est configuré pour être connecté ou combiné à une carte de capteur (40) ou de qubit (41), le circuit inférieur (1) étant configuré pour être connecté ou combiné respectivement à une carte de contrôle (42, 43) de la carte de capteur (40) ou de qubit (41).

13. Système selon la revendication 12, dans lequel un élément intercalaire (44) est disposé entre le circuit supérieur (2) et la carte de capteur (40) ou de qubit (41), de façon à surélever la carte de capteur (40) ou de qubit (41) selon l'axe (7) perpendiculaire au plan de l'ouverture de l'enceinte.

14. Procédé de fabrication du système d'interposeur thermique selon l'une des revendications précédentes, comprenant les étapes de :
- fabrication du circuit inférieur (1), du circuit supérieur (2) et du circuit médian (6) ;
- positionner le circuit inférieur (1) dans l'enceinte (3), le circuit supérieur (2) en-dehors de l'enceinte (3) et le circuit médian (6) dans ou en-dehors de l'enceinte (3) ;
dans lequel le circuit supérieur (2) et le circuit médian (6) sont fabriqués par les sous-étapes suivantes :
- oxydation thermique à la surface d'un substrat (50), de façon à obtenir une couche oxydée (51) ;
- réalisation d'un routage à un ou plusieurs niveaux supraconducteur
- dépôt de plots multicouche supraconducteurs (27) ;
- dépôt d'un écran thermique et de plots conducteurs
- collage, sur la face avant du circuit, d'un substrat en silicium (56), par l'intermédiaire d'une couche de colle (57) ;
- gravure de vias traversants (45) ;
- dépôt d'une couche de métallisation (60) sur la surface arrière complète du circuit, sur les flancs et sur le fond de chaque via et formation de pistes de routages en face arrière du circuit par dépôt semi additif ;
- formation par électrolyse de microbilles conductrices (28) ;
- décollement afin de retirer le substrat en silicium (56) et la couche de colle (57).

15. Procédé selon la revendication 14, dans lequel le substrat (50) d'au moins un des circuits parmi le circuit inférieur (1), le circuit supérieur (2) et le circuit médian (6) comprend au moins un circuit intégré.

16. Procédé selon l'une des revendications 14 ou 15, dans lequel le substrat (50) d'au moins un des circuits parmi le circuit inférieur (1), le circuit supérieur (2) et le circuit médian (6) ne comprend que des composants aptes à effectuer du routage passif de signaux.
